# EUROPEAN PATENT APPLICATION

(11) **EP 3 930 009 A1**
(43) Date of publication of application: **29.12.2021**
(21) Application number: 20766611.6
(22) Date of filing: 25.02.2020
(51) Int. Cl.: H01L 31/0224, H01L 31/048, H01L 31/18, H01L 31/05

(54) **BACK-CONTACT SOLAR CELL CONDUCTIVE COMPOSITE BOARD AND PREPARATION METHOD THEREFOR, BACK-CONTACT SOLAR CELL INTERCONNECTION STRUCTURE, AND DOUBLE-SIDED BACK-CONTACT SOLAR CELL ASSEMBLY**

(30) Priority: 05.03.2019 CN 201910162575; 05.03.2019 CN 201910162816; 05.03.2019 CN 201910163100
(71) Applicant: Longi Solar Technology (Taizhou) Co., Ltd., Taizhou, Jiangsu 225300 (CN)
(72) Inventor: LI, Hua, Taizhou, Jiangsu 225300 (CN); LIU, Jiyu, Taizhou, Jiangsu 225300 (CN)
(74) Representative: Loo, Chi Ching
(86) International application number: PCT/CN2020/076645
(87) International publication number: WO 2020/177581

(57) **Abstract**

The application provides a back-contact solar-cell conductive composite panel and preparation method therefor, a back-contact solar-cell interconnection structure and a double-sided back-contact solar-cell module during lamination. The conductive composite panel includes a conductive connection layer and a base layer made of a thermoplastic material, and the conductive connection layer is embedded in the base layer made of the thermoplastic material; and the conductive connection layer includes a plurality of conductive metal wires and a bus bar connected to the conductive metal wires, and the conductive metal wires are configured for being electrically connected to a back electrode of a back-contact solar-cell sheet. The beneficial effects of the application are as follows: the conductive composite panel provided by the application has simple structure and low cost; and is easily cut into various sizes and shapes, is convenient for use in combination with various back panels, and has flexible application scenarios; when configured for connection with the back-contact solar cell, the conductive composite panel has the advantages of being highly efficient, resistant to hidden cracks, and capable of achieving thin cells, thereby reducing cost and being suitable for a variety of solar cell structures such as MWT, EWT, and IBC.

## Description

The present application claims the priorities of the Chinese patent application filed on March 05th, 2019 before the Chinese Patent Office with the application number of 201910162575.6 and the title of "BACK-CONTACT SOLAR-CELL CONDUCTIVE COMPOSITE PANEL AND PREPARATION METHOD THEREFOR", and the Chinese patent application filed on March 05th, 2019 before the Chinese Patent Office with the application number of 201910162816.7 and the title of "BACK-CONTACT SOLAR-CELL INTERCONNECTION STRUCTURE", and the Chinese patent application filed on March 05th, 2019 before the Chinese Patent Office with the application number of 201910163100.9 and the title of "DOUBLE-SIDED BACK-CONTACT SOLAR-CELL MODULE", the entire contents of which are incorporated herein by reference.

### TECHNICAL FIELD

The present application relates to the technical field of solar cells, and particularly relates to a back-contact solar-cell conductive composite panel and preparation method therefor, a back-contact solar-cell interconnection structure, and a double-sided back-contact solar-cell module.

### BACKGROUND

At present, back-contact solar cells (such as IBC, MWT and EWT solar cells) have been widely concerned. Since no main grid lines or even any electrode patterns are provided on the front side of the cell, and positive and negative electrodes are both arranged on the back side of the cell, the shading of a cell sheet is reduced, thus effectively increasing a short-circuit current of the cell and improving the energy conversion efficiency of the cell. Because the short-circuit current of the back-contact solar-cell is much higher than that of conventional cells, series resistance of a back-contact solar cell module during manufacturing needs to be reduced as much as possible to reduce the ohmic loss of the module and improve the light conversion efficiency of the module.

Two methods including solder strip welding or conductive backplane connection are mainly employed in the interconnection of the existing back-contact solar-cell module. As for the solder strip welding method, the traditional welding method can't be directly used to connect the cell sheets since a stress generated after cooling by single-sided welding will bend the cell sheets, and cause a very high fragmentation rate. In order to solve these problems caused by plane welding, it is necessary to pre-bend the cell sheets on a bending mechanism to a certain extent and then weld the cell sheets in series to form a cell string. Bent welding is realized by a manual welding process, the production efficiency of which is lower. When a conductive backplane and a conductive adhesive are used to realize the conductive interconnection between the back-contact cell sheets, the conductive backplane is composed of patterned copper foil layers and backplane layers in a laminated manner. The large-area use of the copper foil layers leads to high production cost of the back-contact solar-cell module, which is also the main reason why the back-contact solar-cell module is not mass-produced at present.

Therefore, it is of great practical significance to develop a conductive composite panel with low cost, high production efficiency and high adaptability for a back-contact solar-cell module.

### SUMMARY

The present application aims at overcoming the shortcomings of the prior art, and providing a back-contact solar-cell conductive composite panel and preparation method therefor, a back-contact solar-cell interconnection structure and a double-sided back-contact solar-cell module, which can solve the problem of fragmentation caused to the module during lamination.

According to a first aspect, the present application provides a back-contact solar-cell conductive composite panel, wherein the conductive composite panel includes a conductive connection layer and a base layer, the base layer is made of a thermoplastic material, and the conductive connection layer is embedded in the base layer; the conductive connection layer includes a plurality of conductive metal wires and a bus bar connected to the conductive metal wires, and the conductive metal wires are configured for being electrically connected to a back electrode of a back-contact solar-cell sheet.

According to a second aspect, the present application further discloses a preparation method for a back-contact solar-cell conductive composite panel, including the following steps of:
S1. processing conductive metal into a conductive connection layer, wherein the conductive connection layer includes a plurality of conductive metal wires and a bus bar connected with the conductive metal wires;
S2. processing the conductive connection layer and the base layer into a conductive composite prophase panel; and
S3. cutting the conductive composite prophase panel to form the conductive composite panel.

According to a third aspect, the present application further discloses a back-contact solar-cell interconnection structure, wherein the interconnection structure includes a plurality of back-contact solar-cell sheets and the back-contact solar-cell conductive composite panel mentioned above.

According to a fourth aspect, the present application further discloses a double-sided back-contact solar-cell module, wherein the double-sided back-contact solar-cell module includes a front cover panel, a front packaging material, the back-contact solar-cell interconnection structure mentioned above and a back cover panel from top to bottom in sequence.

The above description is only a summary of the technical solutions of the present application. To understand the technical means of the present application more clearly so that the present application can be implemented according to the contents of the specification, and to make the above and other objects, features and advantages of the present application more obvious and understandable, the specific embodiments of the present application are specially illustrated hereinafter.

### BRIEF DESCRIPTION OF THE DRAWINGS

In order to illustrate the technical solutions of the embodiments of the present application or in the related art more clearly, the drawings used in the description of the embodiments or the prior art will be briefly described below. Obviously, the drawings in the following description are merely some embodiments of the present application. For those of ordinary skills in the art, other drawings may also be obtained based on these drawings without going through any creative effort.
FIG. 1 is a schematic diagram of a conductive composite panel according to one embodiment of the present application.
FIG. 2 is a schematic diagram of a conductive composite panel according to another embodiment of the present application.
FIG. 3 is a schematic diagram of a solar cell interconnection structure according to one embodiment of the present application.
FIG. 4 is a schematic diagram of a solar cell interconnection structure according to another embodiment of the present application.
FIG. 5 is a schematic diagram of a solar cell interconnection structure according to one another embodiment of the present application.
FIG. 6 is a schematic sectional view of a solar cell interconnection structure according to one embodiment of the present application.
FIG. 7 is a schematic sectional view of a solar cell interconnection structure according to another embodiment of the present application.
FIG. 8 is a schematic structural diagram of a back electrode of a solar cell according to one embodiment of the present application.
FIG. 9 is a schematic structural diagram of a back electrode of a solar cell according to another embodiment of the present application.
FIG. 10 is a schematic structural diagram of a back electrode of a solar cell according to one another embodiment of the present application.
FIG. 11 is a schematic diagram of a sectional structure of a conductive metal wire according to one embodiment of the present application.
FIG. 12 is a schematic diagram of a sectional structure of a conductive metal wire according to another embodiment of the present application.
FIG. 13 is a schematic diagram of a sectional structure of a solar-cell module according to one embodiment of the present application.
FIG. 14 is a schematic diagram of a solar-cell module according to another embodiment of the present application.sheet

In the figures, 1 refers to base layer, 2 refers to conductive metal wire, 3 refers to bus bar, 21 refers to first conductive metal wire, 22 refers to second conductive metal wire, 23 refers to third conductive metal wire, 24 refers to bend, 10 refers to solar-cell sheet, 5 refers to insulating medium layer, 6 refers to electrical connection material, 25 refers to hot-melt conducting layer, 11 refers to P-type doped region, 12 refers to N-type doped region, 13 refers to P-type electrode, 14 refers to N-type electrode, 131 refers to P-type fine-grid line electrode, 132 refers to P-type connection electrode, 141 refers to N-type fine-grid line electrode, 142 refers to N-type connection electrode, 100 refers to front cover panel, 200 refers to front packaging material, and 300 refers to back cover panel.

### DETAILED DESCRIPTION

In order to make the objects, the technical solutions and the advantages of the embodiments of the present application clearer, the technical solutions of the embodiments of the present application will be clearly and completely described below with reference to the drawings of the embodiments of the present application. Apparently, the described embodiments are merely certain embodiments of the present application, rather than all of the embodiments. Based on the embodiments of the present application, all other embodiments obtained by those of ordinary skills in the art without going through any creative effort shall fall within the scope of protection of the present application.

### First embodiment

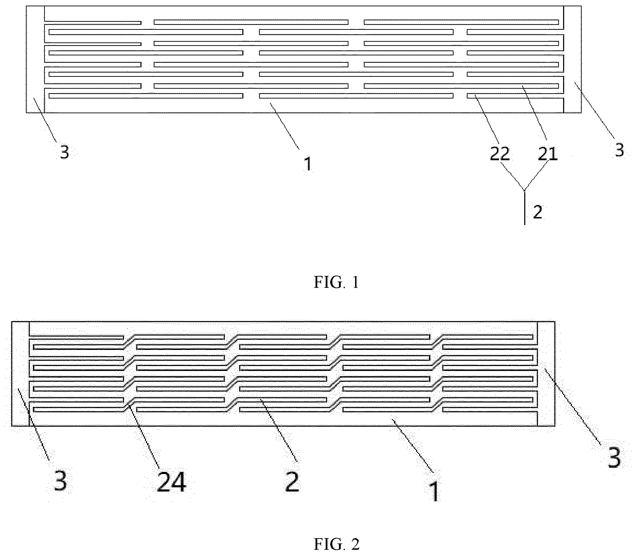

As shown in FIGs. 1 to 2, the present application provides a back-contact solar-cell conductive composite panel. The conductive composite panel includes a conductive connection layer and a base layer 1. The base layer is made of a thermoplastic material, and the conductive connection layer is embedded in the base layer 1. The conductive connection layer includes a plurality of conductive metal wires 2 and a bus bar 3 connected to the conductive metal wires 2, and the conductive metal wires 2 are configured for being electrically connected to a back electrode of a back-contact solar-cell sheet. Optionally, a thickness of the base layer 1 made of thermoplastic material is no less than 300 µm. The conductive composite panel of the present application includes two layers including the base layer and the conductive structure layer, which, compared with the prior art, and has simpler structure and lower cost. According to the present application, the conductive connection layer is embedded in the base layer made of the thermoplastic material by a laminating process first, and then the conductive connection layer is connected with the back electrode of the back-contact solar-cell sheet, which can realize flexible interconnection, thus avoiding fragmentation to the module caused during laminating. Moreover, the conductive composite panel of the present application is easily cut into various sizes and shapes, is convenient for use in combination with various back panels, and has flexible application scenarios; when configured for connection with the back-contact solar cell, the conductive composite panel has the advantages of being highly efficient, resistant to hidden cracks, and capable of achieving thin cells, thereby reducing cost and being suitable for a variety of solar cell structures such as MWT, EWT, and IBC.

In some embodiments, the bus bar 3 is arranged at both ends of the conductive connection layer, and the bus bar 3 is connected with the conductive metal wire 2. The bus bar in this embodiment is configured for converging and outputting a current collected by the conductive metal wire on the solar-cell sheet.

As shown in FIGs. 1 to 2, the conductive metal wires 2 in each row or column are arranged in a multi-segment structure, the conductive metal wires 2 in adjacent rows or columns are arranged at different positions, and the conductive metal wires 2 in spaced rows or columns are arranged at the same position.

Preferably, as shown in FIGs. 1 to 2, a tail end of an n^{th} conductive metal wire 2 in each row is close to a central position of an n^{th} conductive metal wire 2 in the adjacent row, and a starting end of an (n+1)^{th} conductive metal wire 2 in each row is close to the central position of the n^{th} conductive metal wire 2 in the adjacent row; or, a tail end of an n^{th} conductive metal wire 2 in each column is close to a central position of an n^{th} conductive metal wire in the adjacent column, and a starting end of an (n+1)^{th} conductive metal wire 2 in each column is close to the central position of the n^{th} conductive metal wire 2 in the adjacent column; and n is greater than or equal to 1.

As shown in FIG. 1, in some embodiments, the conductive metal wires include first conductive metal wires 21 and second conductive metal wires 22 which are parallel to each other and arranged at intervals, the first conductive metal wires 21 are connected with an N-type main grid on a back of a (2n-1)^{th} solar-cell sheet and a P-type main grid on a back of a 2n^{th} solar-cell sheet, and the second conductive metal wires 22 are connected with a P-type main grid on a back of a (2n+1)^{th} solar-cell sheet and an N-type main grid on the back of the 2n^{th} solar-cell sheet; wherein, the 2n^{th} solar-cell sheet, after rotating for 180 degrees, is aligned with the (2n-1)^{th} solar-cell sheet.

Preferably, distances between the first conductive metal wires 21 and the second conductive metal wires 22 are equal.

As shown in FIG. 2, in some embodiments, a plurality of bends 24 are arranged on the conductive metal wires 2, and the bends 24 are located at joints of the solar-cell sheets, the conductive metal wires before the bends 24 are connected with N-type main grids of each row or column of solar-cell sheets, and the conductive metal wires behind the bends 24 are connected with P-type main grids of each adjacent row or column of solar-cell sheets; wherein, the adjacent solar-cell sheets in this embodiment are arranged and aligned in sequence, and the operation process is simple.

Preferably, the bend 24 is a Z-shaped structure.

In yet other embodiments, the conductive metal wires further include third conductive metal wires distributed in a discrete way, and the third conductive metal wires are configured for being connected with secondary grids on the backs of the solar-cell sheets.

The back-contact solar-cell sheet according to the present application may be a whole back-contact solar-cell sheet, and may also be a solar-cell sub-sheet formed by cutting the whole back-contact solar-cell sheet. The solar-cell sub-sheet may be one half, one third, one quarter, one fifth or one sixth of the whole solar-cell sheet.

Preferably, a spacing between adjacent conductive metal wires ranges from 0.1 mm to 20 mm.

A cross-sectional shape of the conductive metal wire is one or any combination of round, square, ellipse, rectangle, hexagon, octagon, trapezoid or diamond.

The present application further provides a preparation method for a back-contact solar-cell conductive composite panel, including the following steps of:
S1. processing conductive metal into a conductive connection layer, wherein the conductive connection layer includes a plurality of conductive metal wires and a bus bar connected with the conductive metal wires;
S2. processing the conductive connection layer and the base layer into a conductive composite prophase panel; and
S3. cutting the conductive composite prophase panel to form the conductive composite panel.

In some embodiments, in step S1, the conductive metal wires include first conductive metal wires and second conductive metal wires which are parallel to each other and arranged at intervals, the first conductive metal wires are connected with an N-type main grid on a back of a (2n-1)^{th} solar-cell sheet and a P-type main grid on a back of a 2n^{th} solar-cell sheet, and the second conductive metal wires are connected with a P-type main grid on a back of a (2n+1)^{th} solar-cell sheet and an N-type main grid on the back of the 2n^{th} solar-cell sheet; wherein, the 2n^{th} solar-cell sheet, after rotating for 180 degrees, is aligned with the (2n-1)^{th} solar-cell sheet. n step S2, the conductive connection layer is embedded in the base layer by hot pressing process to form the conductive composite panel. Preferably, in step S2, the hot pressing process is a pre-laminating process with a laminator, wherein the hot pressing is performed at a temperature ranging from 50°C to 120°C, and the hot pressing lasts for 5 seconds to 30 seconds.

In some other embodiments, in step S1, a plurality of bends are arranged on the conductive metal wires, and the bends are located at joints of the solar-cell sheets, the conductive metal wires before the bends are connected with N-type main grids of each row or column of solar-cell sheets, and the conductive metal wires behind the bends are connected with P-type main grids of each adjacent row or column of solar-cell sheets; wherein, the adjacent solar-cell sheets are arranged and aligned in sequence. In step S2, the conductive connection layer is embedded in the base layer by hot pressing process to form the conductive composite panel; or, the conductive connection layer is bonded on the base layer to form the conductive composite panel.

In step S1, the conductive metal is processed by mechanical punching, laser punching or chemical etching. In some embodiments, laser punching is preferred. The laser machining method has the characteristics of high machining accuracy and high machining efficiency, and is suitable for occasions with fine design and high dimensional accuracy requirements for conductive composite panels. In some other embodiments, laser machining is not suitable for occasions where the number of conductive metal wires is small and the diameter or thickness is high, and machining is preferred, which can also reduce the machining cost.

The material of the base layer is one or any combination of polyvinyl butyral, polyolefin or ethylene-vinyl acetate copolymer.

The conductively metal includes one or any combination of copper, silver, aluminum, nickel, magnesium, iron, titanium, molybdenum, tungsten and alloys thereof.

### Second embodiment

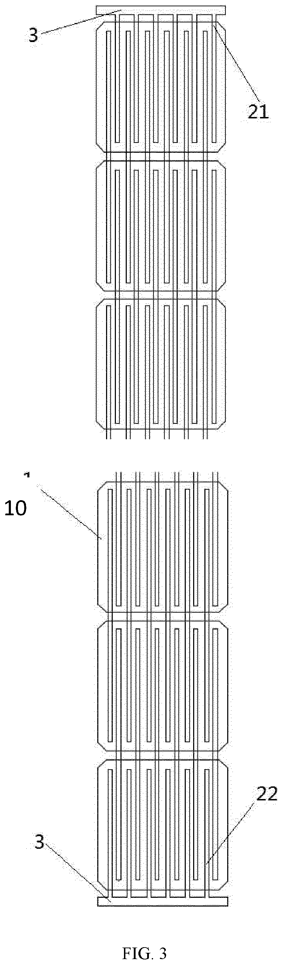

As shown in FIGs. 3 to 7, the present application further provides a back-contact solar-cell interconnection structure, including a plurality of back-contact solar-cell sheets 10 and the back-contact solar-cell conductive composite panel. The back-contact solar-cell conductive composite panel may be understood with reference to the first embodiment, and will not be described in detail here.

The back-contact solar-cell sheet according to the present application may be a whole back-contact solar-cell sheet, and may also be a solar-cell sub-sheet formed by cutting the whole back-contact solar-cell sheet. The solar-cell sub-sheet may be one half, one third, one quarter, one fifth or one sixth of the whole solar-cell sheet. According to the present application, the conductive metal wires and the bus bar are both embedded in a thermoplastic packaging material by a pre-laminating process first, and then the conductive metal wires are connected with the back electrode of the back-contact solar-cell sheet, which can realize flexible interconnection, thus avoiding fragmentation to the module caused during laminating. Furthermore, the parallel and staggered conductive metal wires are arranged to realize electrical connection with the back electrode of the back-contact solar-cell sheet, so that the present application can be flexibly arranged, cut and interconnected according to an area of the cell sheet and a pattern of the back electrode of the cell sheet, and has the advantages of small interconnection contact resistance, flexible and reliable connection mode and the like, and is suitable for a variety of cells such as MWT, EWT, and IBC.

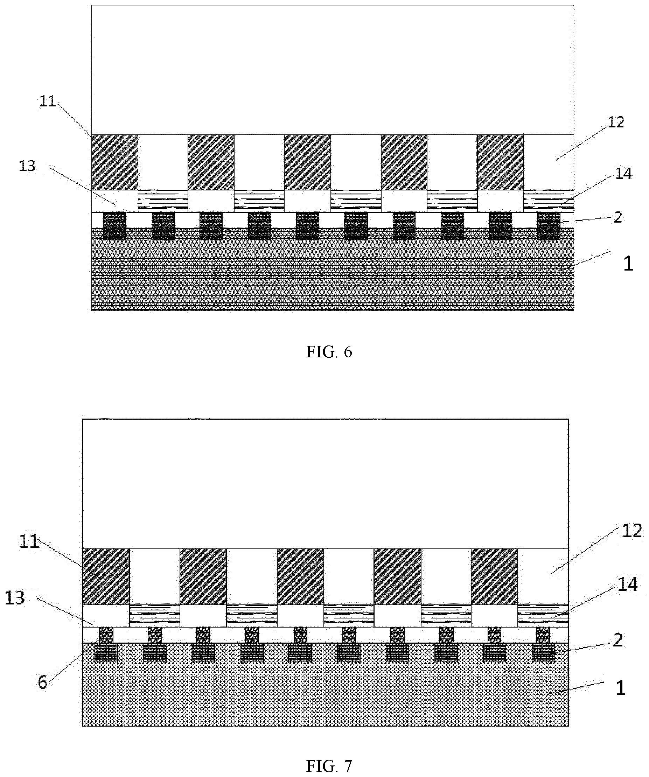

As shown in FIGs. 6 to 7, wherein a back electrode of the back-contact solar-cell sheet includes a P-type electrode 13 contacted with a P-type doped region 11 and an N-type electrode 14 contacted with an N-type doped region 12.

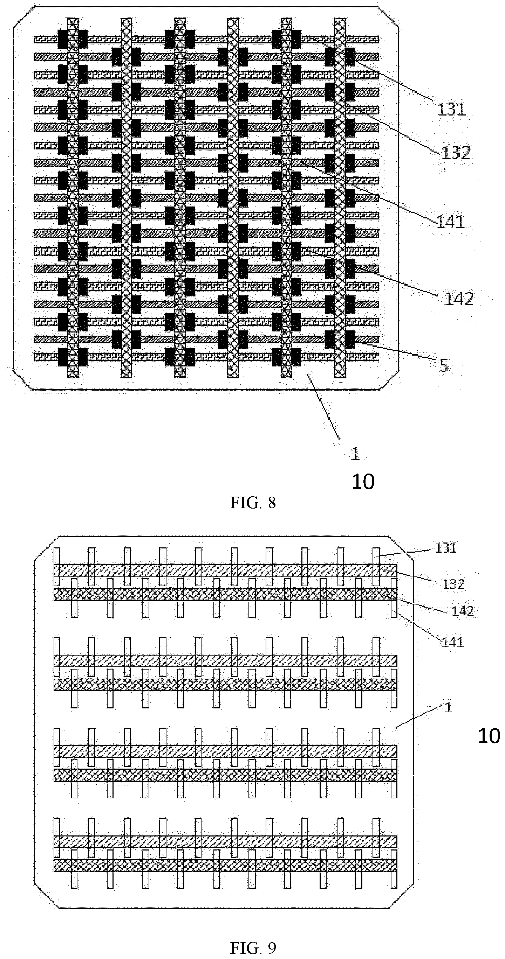

As shown in FIGs. 8 to 10, the P-type electrode 13 includes a P-type fine-grid line electrode 131 and a P-type connection electrode 132, and the N-type electrode 14 includes an N-type fine-grid line electrode 141 and an N-type connection electrode 142. The P-type fine-grid line electrode 131 is connected with the P-type connection electrode 132, and the N-type fine-grid line electrode 141 is connected with the N-type connection electrode 142. The P-type connection electrode 132 is configured for outputting a current on the P-type fine-grid line electrode 131, and the N-type connection electrode 142 is configured for outputting a current on the N-type fine-grid line electrode 141.

As shown in FIG. 8, in some embodiments, the P-type fine-grid line electrode 131 is a P-type continuous fine-grid line electrode, the N-type fine-grid line electrode 141 is an N-type continuous fine-grid line electrode, the P-type connection electrode 132 is a P-type continuous connection electrode, the N-type connection electrode 142 is an N-type continuous connection electrode, the P-type continuous fine-grid line electrode is connected with the P-type continuous connection electrode, and the N-type continuous fine-grid line electrode is connected with the N-type continuous connection electrode. An insulating medium layer 5 is arranged at an intersection of the P-type continuous connection electrode and the N-type continuous fine-grid line electrode, and an insulating medium layer 5 is arranged at an intersection of the N-type continuous connection electrode and the P-type continuous fine-grid line electrode. The total number of the P-type connection electrodes 132 and the N-type connection electrodes 142 ranges from 8 to 250.

As shown in FIG. 9, in some other embodiments, the P-type fine-grid line electrode 13 is a P-type segmented fine-grid line electrode, the N-type fine-grid line electrode 141 is an N-type segmented fine-grid line electrode, and the P-type segmented fine-grid line electrode and the N-type segmented fine-grid line electrode are staggered from each other. The P-type connection electrode 132 is a P-type continuous connection electrode, and the N-type connection electrode 142 is an N-type continuous connection electrode. The P-type continuous connection electrode is configured for connecting P-type segmented fine-grid line electrodes on the same row or column, and the N-type continuous connection electrode is configured for connecting N-type segmented fine-grid line electrodes on the same row or column. In this embodiment, both the P-type fine-grid line electrode and the N-type fine-grid line electrode are set as segmented electrodes, so as to reduce a series resistance and a current transmission distance, and improve the efficiency.

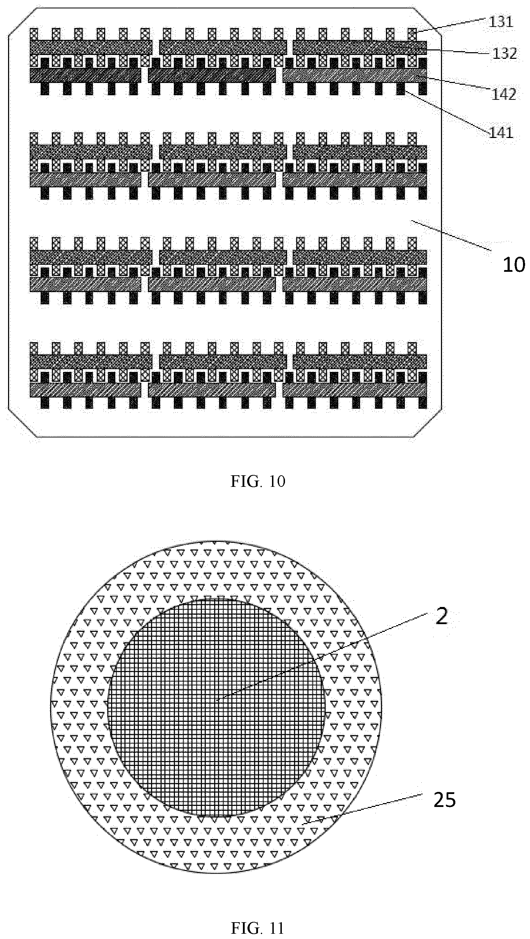

As shown in FIG. 10, in other embodiments, the P-type fine-grid line electrode 131 is a P-type segmented fine-grid line electrode, the N-type fine-grid line electrode 141 is an N-type segmented fine-grid line electrode, the P-type segmented fine-grid line electrode and the N-type segmented fine-grid line electrode are staggered from each other, the P-type connection electrode 132 is a P-type segmented connection electrode, and the N-type connection electrode 142 is an N-type segmented connection electrode. The P-type segmented connection electrode is configured for connecting P-type segmented fine-grid line electrodes on the same row or column in a segmented manner, and the N-type segmented connection electrode is configured for connecting N-type segmented fine-grid line electrodes on the same row or column in a segmented manner. The segmented connection electrode may be several segments that are not on the same straight line. In this case, the total number of the connection electrodes is much larger than 8 to 250. The segmented connection electrodes may also be several segments on the same straight line. When the segmented connection electrodes are on the same straight line, the conductive metal wires may connect all the segmented connection electrodes. When the segmented connection electrodes are not on the same straight line, the conductive metal wires may only be connected to several segmented connection electrodes located on the same straight line, and other segmented connection electrodes which are not connected with the conductive metal wires may play the role of the third conductive metal wires -- similar to the role of an anti-broken grid, and the segmented connection electrodes in this part are connected with the segmented fine-grid line electrodes. In this embodiment, both the P-type fine-grid line electrode and the N-type fine-grid line electrode are set as segmented electrodes to reduce the series resistance and the current transmission distance, and improve the efficiency. Meanwhile, both the P-type connection electrode and the N-type connection electrode are set as segmented electrodes to reduce the dosage of silver paste. The fine-grid line electrodes and the connecting electrodes are both set as segmented electrodes, and the segmented connection electrodes are configured for connecting the segmented fine-grid line electrodes on the same row or column in segments, so that the back electrode of the cell sheet is connected with the conductive metal wires after forming a "Chinese-character-feng"-shaped structure, thus effectively dispersing stress and reducing stress on the cell sheet.

As shown in FIGs. 3 to 5, the conductive metal wires 2 in each row or column are arranged in a multi-segment structure, the conductive metal wires 2 in adjacent rows or columns are arranged at different positions, and the conductive metal wires 2 in spaced rows or columns are arranged at the same position.

Preferably, as shown in FIGs. 3 to 5, a tail end of an n^{th} conductive metal wire 2 in each row is close to a central position of an n^{th} conductive metal wire 2 in the adjacent row, and a starting end of an (n+1)^{th} conductive metal wire 2 in each row is close to the central position of the n^{th} conductive metal wire 2 in the adjacent row; or, a tail end of an n^{th} conductive metal wire 2 in each column is close to a central position of an n^{th} conductive metal wire in the adjacent column, and a starting end of an (n+1)^{th} conductive metal wire 2 in each column is close to the central position of the n^{th} conductive metal wire 2 in the adjacent column.

As shown in FIG. 3, in some embodiments, the bus bar 3 is arranged at both ends of the conductive connection layer, and the conductive metal wires 2 include first conductive metal wires 21 and second conductive metal wires 22 which are parallel to each other and arranged at intervals. The first conductive metal wires 21 are connected with a P-type connection electrode 132 of a 2n^{th} solar-cell sheet and an N-type connection electrode 142 of a (2n-1)^{th} solar-cell sheet, and the second conductive metal wires 22 are connected with a P-type connection electrode 132 of a (2n+1)^{th} solar-cell sheet and an N-type connection electrode 142 of an 2n^{th} solar-cell sheet. The total number of the first conductive metal wires 21 and the second conductive metal wires 22 connected on each back-contact solar-cell sheet ranges from 8 to 50. In this embodiment, the 2n^{th} solar-cell sheet 1 is rotated by 180 degrees first, and then aligned with the (2n-1)^{th} solar-cell sheet, and n is greater than or equal to 1.

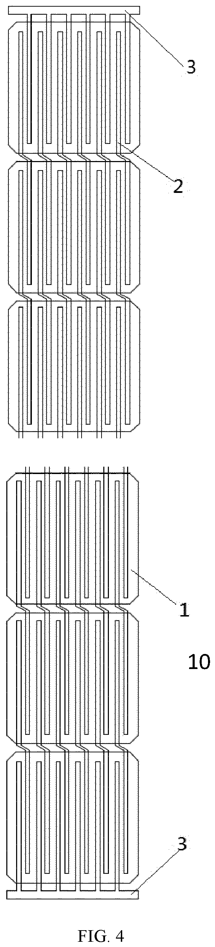

As shown in FIG. 4, in some other embodiments, the bus bar 3 is arranged at both ends of a conductive composite layer, and the conductive metal wires 2 are parallel to each other in a Z shape and staggered. An N-type connection electrode 142 of a latter solar-cell sheet is connected with a P-type connection electrode 132 of an adjacent former solar-cell sheet through the Z-shaped conductive metal wire. In this embodiment, the adjacent solar-cell sheets 1 are directly arranged and aligned in sequence without turning over.

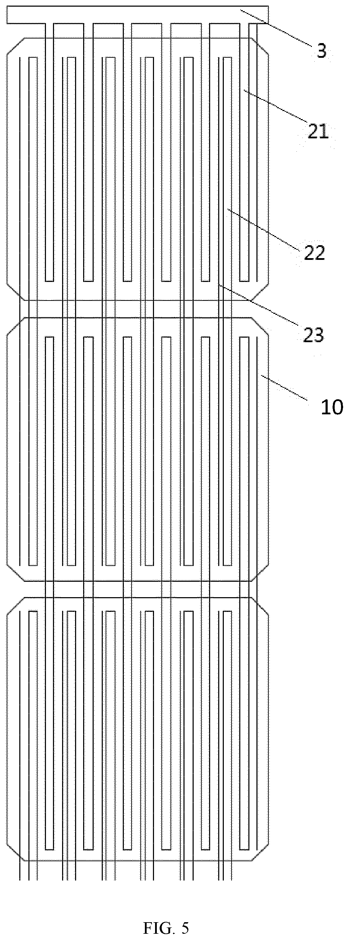

As shown in FIG. 5, in some embodiments, the conductive metal wires further include third conductive metal wires 23 distributed in a discrete way, and the third conductive metal wires 23 are configured for being connected with the P-type fine-grid line electrode and/or the N-type fine-grid line electrode on the back of the solar-cell sheet.

A cross-sectional shape of the conductive metal wire 2 may be one or any combination of round, square, ellipse, rectangle, hexagon, octagon, trapezoid or diamond. A spacing between adjacent conductive metal wires ranges from 0.1 mm to 20 mm.

Preferably, as shown in FIG. 6, the interconnection structure further includes an electrical connection material 6, the electrical connection material 6 is arranged on the conductive metal wire 2, and the electrical connection material 6 is configured for electrically connecting a back electrode of the back-contact solar-cell sheet 1 with the conductive composite panel. The electrical connection material includes one or any combination of conductive paste, solder, solder paste, conductive ink, isotropic conductive adhesive, anisotropic conductive adhesive or low-melting-point metal alloy.

Preferably, as shown in FIGs. 11 to 12, a surface of the conductive metal wire 2 is provided with a hot-melt conducting layer 25, and the hot-melt conducting layer 25 is configured for electrically connecting a back electrode of the back-contact solar-cell sheet with the electric connection layer. The hot-melt conducting layer 25 is a metal or alloy with a melting point between 70°C and 300°C; or, the material of the hot-melt conducting layer is conductive resin with a softening temperature ranging from 90°C to 120°C.

In one embodiment, the electrical connection between the back electrode of the back-contact solar-cell sheet and the conductive composite panel is realized by laminating the hot-melt conducting layer arranged on the surface of the conductive metal wire. In another embodiment, the electrical connection between the back electrode of the back-contact solar-cell sheet and the conductive composite panel is realized by connecting the connection electrode on the back of the back-contact solar cell with the conductive metal wire through the electrical connection material.

Preferably, the conductive composite panel is formed by a laminating process, wherein the laminating is performed at a temperature ranging from 135°C to 165°C, and the laminating lasts for 6 minutes to 30 minutes.

Preferably, the insulating medium includes one or any combination of polyimide (PI), polybenzoxazole (PBO), benzocyclobutene (BCB) epoxy resin, polyurethane resin, acrylic resin, organosilicon resin, polyvinyl acetal resin or solder resist film (SR).

### Third embodiment

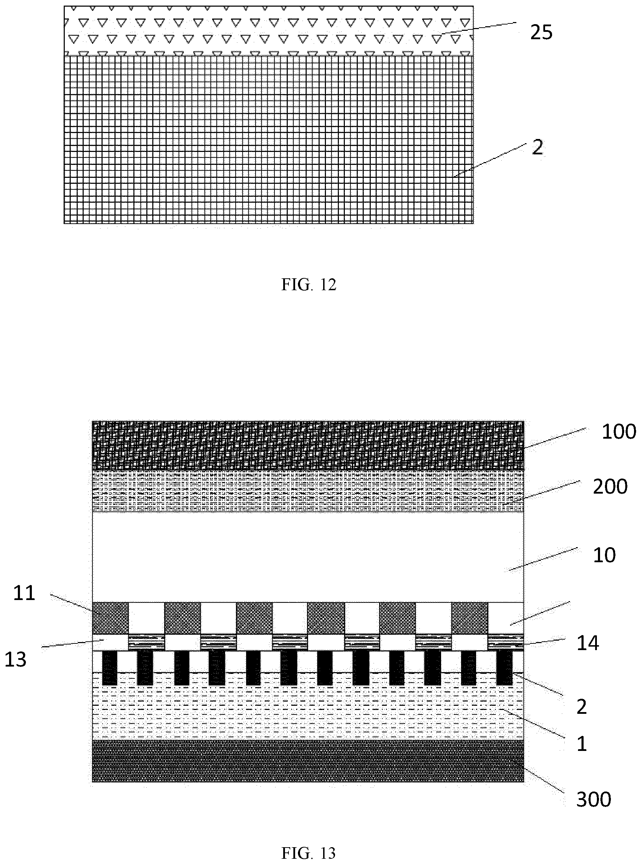

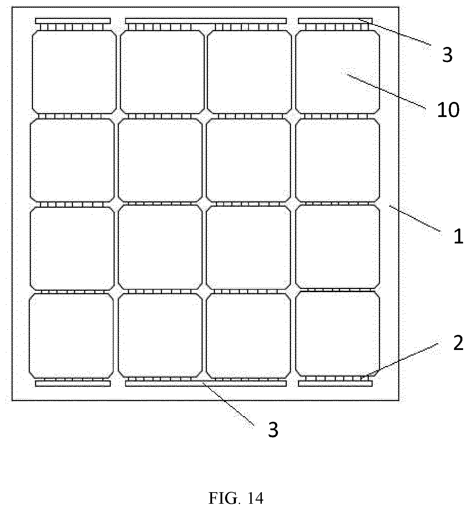

As shown in FIGs. 13 to 14, the present application provides a double-sided back-contact solar-cell module, wherein the double-sided back-contact solar-cell module includes a front cover panel 100, a front packaging material 200, the back-contact solar-cell interconnection structure and a back cover panel 300 from top to bottom in sequence. The interconnection structure includes a plurality of back-contact solar-cell sheets 10 and the back-contact solar-cell conductive composite panel. The interconnection structure may be understood with reference to the second embodiment, and will not be described in detail here.

The back cover panel is made of a transparent material or a material which is transparent after being laminated. The back-contact solar-cell sheet according to the present application may be a whole back-contact solar-cell sheet, and may also be a solar-cell sub-sheet formed by cutting the whole back-contact solar-cell sheet. The solar-cell sub-sheet may be one half, one third, one quarter, one fifth or one sixth of the whole solar-cell sheet. According to the present application, the conductive metal wires and the bus bar are both embedded in a thermoplastic packaging material by a pre-laminating process first, and then the conductive metal wires are connected with the back electrode of the back-contact solar-cell sheet, which can realize flexible interconnection, thus avoiding fragmentation to the module caused during laminating. Furthermore, the parallel and staggered conductive metal wires are arranged to realize electrical connection with the back electrode of the back-contact solar-cell sheet, so that the back-contact solar-cell sheet of the present application can be flexibly arranged, cut and interconnected according to an area of the cell sheet and a pattern of the back electrode of the cell sheet, and has the advantages of small interconnection contact resistance, flexible and reliable connection mode and the like, and is suitable for a variety of cells such as MWT, EWT, and IBC. In addition, the flexible packaging of the back-contact solar-cell module and the double-sided power generation of the back-contact solar-cell module in the application improve the power generation output power of the solar-cell module.

Preferably, both the materials of the front packaging material 2 and the base layer 1 are one or any combination of polyvinyl butyral, polyolefin or ethylene-vinyl acetate copolymer.

Preferably, the insulating medium layer includes one or any combination of polyimide (PI), polybenzoxazole (PBO), benzocyclobutene (BCB) epoxy resin, polyurethane resin, acrylic resin, organosilicon resin, polyvinyl acetal resin or solder resist film (SR).

Preferably, the back cover panel 300 is tempered glass, or the back cover panel 300 is a polymer back panel which is transparent after being laminated. More preferably, a substrate layer of the polymer back panel is polyethylene terephthalate (PET), and fluorocarbon coatings are coated on both sides of the substrate layer. In this embodiment, the back cover panel is made of polyethylene glycol terephthalate, so that the mass of the solar-cell module prepared in this embodiment is lighter, which is more conducive to the installation of the module.

The above-described device embodiments are merely illustrative, wherein the units that are described as separate components may or may not be physically separate, and the components that are displayed as units may or may not be physical units; in other words, they may be located at the same one location, and may also be distributed to a plurality of network units. Part or all modules therein may be selected according to actual needs to realize the objective of achieving the technical solution of the embodiment. Those of ordinary skills in the art can understand and implement the technical solutions without paying creative work.

The "one embodiment", "an embodiment" or "one or more embodiments" as used herein means that particular features, structures or characteristics described with reference to an embodiment are included in at least one embodiment of the present application. Moreover, it should be noted that here an example using the wording "in an embodiment" does not necessarily refer to the same one embodiment.

Many details are discussed in the specification provided herein. However, it can be understood that the embodiments of the present application may be implemented without those concrete details. In some of the embodiments, well-known processes, structures and techniques are not described in detail, so as not to affect the understanding of the description.

In the claims, any reference signs between parentheses should not be construed as limiting the claims. The word "include" does not exclude elements or steps that are not listed in the claims. The word "a" or "an" preceding an element does not exclude the existing of a plurality of such elements. The present application may be implemented by means of hardware including several different elements and by means of a properly programmed computer. In unit claims that list several devices, some of those devices may be embodied by the same item of hardware. The words first, second, third and so on do not denote any order. Those words may be interpreted as names.

It should be finally noted that the above embodiments are only used to illustrate the technical solution of the present application, rather than limiting the present application. Although the present application is explained in detail by referring to the above embodiments, a person skilled in the art should understand that he can still modify the technical solutions set forth by the above embodiments, or make equivalent substitutions to part of the technical features of them. However, these modifications or substitutions shall not depart from the spirit and scope of the technical solutions of the embodiments of the present application.

## Claims

1. A back-contact solar-cell conductive composite panel, **characterized in that** the conductive composite panel comprises a conductive connection layer and a base layer, the base layer is made of a thermoplastic material, and the conductive connection layer is embedded in the base layer; and the conductive connection layer comprises a plurality of conductive metal wires and a bus bar connected to the conductive metal wires, and the conductive metal wires are configured for being electrically connected to a back electrode of a back-contact solar-cell sheet.

2. The back-contact solar-cell conductive composite panel according to claim 1, **characterized in that** the conductive metal wires in each row or column are arranged in a multi-segment structure, the positions of the conductive metal wires in spaced rows or columns correspond to each other, while the positions of the conductive metal wires in adjacent rows or columns do not correspond to each other.

3. The back-contact solar-cell conductive composite panel according to claim 2, **characterized in that** a tail end of an n^{th} conductive metal wire in each row is close to a central position of an n^{th} conductive metal wire in the adjacent row, and a starting end of an (n+1)^{th} conductive metal wire in each row is close to the central position of the n^{th} conductive metal wire in the adjacent row; or, a tail end of an n^{th} conductive metal wire in each column is close to a central position of an n^{th} conductive metal wire in the adjacent column, and a starting end of an (n+1)^{th} conductive metal wire in each column is close to the central position of the n^{th} conductive metal wire in the adjacent column.

4. The back-contact solar-cell conductive composite panel according to any one of claims 1 to 3, **characterized in that** the conductive metal wires comprise first conductive metal wires and second conductive metal wires which are parallel to each other and arranged at intervals, the first conductive metal wires are connected with an N-type main grid on a back of a (2n-1)^{th} solar-cell sheet and a P-type main grid on a back of a 2n^{th} solar-cell sheet, and the second conductive metal wires are connected with a P-type main grid on a back of a (2n+1)^{th} solar-cell sheet and an N-type main grid on the back of the 2n^{th} solar-cell sheet; wherein, the 2n^{th} solar-cell sheet, after rotating for 180 degrees, is aligned with the (2n-1)^{th} solar-cell sheet.

5. The back-contact solar-cell conductive composite panel according to claim 4, **characterized in that** distances between the first conductive metal wires and the second conductive metal wires are equal.

6. The back-contact solar-cell conductive composite panel according to any one of claims 1 to 3, **characterized in that** a plurality of bends are arranged on the conductive metal wires, and the bends are located at joints of the solar-cell sheets, the conductive metal wires before the bends are connected with N-type main grids of each row or column of solar-cell sheets, and the conductive metal wires behind the bends are connected with P-type main grids of each adjacent row or column of solar-cell sheets; wherein, the adjacent solar-cell sheets are arranged and aligned in sequence.

7. The back-contact solar-cell conductive composite panel according to claim 6, **characterized in that** the bend is a Z-shaped structure.

8. The back-contact solar-cell conductive composite panel according to claim 4, **characterized in that** the conductive metal wires further comprise third conductive metal wires distributed in a discrete way, and the third conductive metal wires are configured for being connected with secondary grids on the backs of the solar-cell sheets.

9. The back-contact solar-cell conductive composite panel according to claim 1, **characterized in that** the back-contact solar-cell sheet is a whole cell sheet or a solar-cell sub-sheet formed by cutting.

10. The back-contact solar-cell conductive composite panel according to claim 1, **characterized in that** the material of the base layer is one or any combination of polyvinyl butyral, polyolefin or ethylene-vinyl acetate copolymer.

11. A preparation method for a back-contact solar-cell conductive composite panel, comprising the following steps of:
S1. processing conductive metal into a conductive connection layer, wherein the conductive connection layer comprises a plurality of conductive metal wires and a bus bar connected with the conductive metal wires;
S2. processing the conductive connection layer and the base layer into a conductive composite prophase panel; and
S3. cutting the conductive composite prophase panel to form the conductive composite panel.

12. The preparation method for the back-contact solar-cell conductive composite panel according to claim 11, **characterized in that** in step S1, the conductive metal wires comprise first conductive metal wires and second conductive metal wires which are parallel to each other and arranged at intervals, the first conductive metal wires are connected with an N-type main grid on a back of a (2n-1)^{th} solar-cell sheet and a P-type main grid on a back of a 2n^{th} solar-cell sheet, and the second conductive metal wires are connected with a P-type main grid on a back of a (2n+1)^{th} solar-cell sheet and an N-type main grid on the back of the 2n^{th} solar-cell sheet; wherein, the 2n^{th} solar-cell sheet, after rotating for 180 degrees, is aligned with the (2n-1)^{th} solar-cell sheet.

13. The preparation method for the back-contact solar-cell conductive composite panel according to claim 12, **characterized in that** in step S2, the conductive connection layer is embedded in the base layer by hot pressing process to form the conductive composite prophase panel.

14. The preparation method for the back-contact solar-cell conductive composite panel according to claim 13, **characterized in that** in step S2, the hot pressing process is a pre-laminating process with a laminator, wherein the hot pressing is performed at a temperature ranging from 50°C to 120°C, and the hot pressing lasts for 5 seconds to 30 seconds.

15. The preparation method for the back-contact solar-cell conductive composite panel according to claim 11, **characterized in that** in step S1, a plurality of bends are arranged on the conductive metal wires, and the bends are located at joints of the solar-cell sheets, the conductive metal wires before the bends are connected with N-type main grids of each row or column of solar-cell sheets, and the conductive metal wires behind the bends are connected with P-type main grids of each adjacent row or column of solar-cell sheets; wherein, the adjacent solar-cell sheets are arranged and aligned in sequence.

16. The preparation method for the back-contact solar-cell conductive composite panel according to claim 15, **characterized in that** in step S2, the conductive connection layer is embedded in the base layer by hot pressing process to form the conductive composite panel; or, the conductive connection layer is bonded on the base layer to form the conductive composite panel.

17. The preparation method for the back-contact solar-cell conductive composite panel according to claim 11, **characterized in that** in step S1, the conductive metal is processed by mechanical punching, laser punching or chemical etching.

18. A back-contact solar-cell interconnection structure, **characterized in that** the interconnection structure comprises a plurality of back-contact solar-cell sheets and the back-contact solar-cell conductive composite panel according to any one of claims 1 to 10.

19. The back-contact solar-cell interconnection structure according to claim 18, wherein a back electrode of the back-contact solar-cell sheet comprises a P-type electrode contacted with a P-type doped region and an N-type electrode contacted with an N-type doped region.

20. The back-contact solar-cell interconnection structure according to claim 19, **characterized in that** the P-type electrode comprises a P-type fine-grid line electrode and a P-type connection electrode, and the N-type electrode comprises an N-type fine-grid line electrode and an N-type connection electrode; the P-type fine-grid line electrode is connected with the P-type connection electrode, and the N-type fine-grid line electrode is connected with the N-type connection electrode; and the P-type connection electrode is configured for outputting a current on the P-type fine-grid line electrode, and the N-type connection electrode is configured for outputting a current on the N-type fine-grid line electrode.

21. The back-contact solar-cell interconnection structure according to claim 20, **characterized in that** the P-type fine-grid line electrode is a P-type continuous fine-grid line electrode, the N-type fine-grid line electrode is an N-type continuous fine-grid line electrode, the P-type connection electrode is a P-type continuous connection electrode, the N-type connection electrode is an N-type continuous connection electrode, the P-type continuous fine-grid line electrode is connected with the P-type continuous connection electrode, and the N-type continuous fine-grid line electrode is connected with the N-type continuous connection electrode; and an insulating medium layer is arranged at an intersection of the P-type continuous connection electrode and the N-type continuous fine-grid line electrode, and an insulating medium layer is arranged at an intersection of the N-type continuous connection electrode and the P-type continuous fine-grid line electrode.

22. The back-contact solar-cell interconnection structure according to claim 20, **characterized in that** the P-type fine-grid line electrode is a P-type segmented fine-grid line electrode, the N-type fine-grid line electrode is an N-type segmented fine-grid line electrode, and the P-type segmented fine-grid line electrode and the N-type segmented fine-grid line electrode are staggered from each other; the P-type connection electrode is a P-type continuous connection electrode, and the N-type connection electrode is an N-type continuous connection electrode; and the P-type continuous connection electrode is configured for connecting P-type segmented fine-grid line electrodes on the same row or column, and the N-type continuous connection electrode is configured for connecting N-type segmented fine-grid line electrodes on the same row or column.

23. The back-contact solar-cell interconnection structure according to claim 20, **characterized in that** the P-type fine-grid line electrode is a P-type segmented fine-grid line electrode, the N-type fine-grid line electrode is an N-type segmented fine-grid line electrode, the P-type segmented fine-grid line electrode and the N-type segmented fine-grid line electrode are staggered from each other, the P-type connection electrode is a P-type segmented connection electrode, and the N-type connection electrode is an N-type segmented connection electrode; and the P-type segmented connection electrode is configured for connecting P-type segmented fine-grid line electrodes on the same row or column in a segmented manner, and the N-type segmented connection electrode is configured for connecting N-type segmented fine-grid line electrodes on the same row or column in a segmented manner.

24. The back-contact solar-cell interconnection structure according to claim 18, **characterized in that** the interconnection structure further comprises an electrical connection material, the electrical connection material is arranged on the conductive metal wire, and the electrical connection material is configured for electrically connecting a back electrode of the back-contact solar-cell sheet with the conductive composite panel.

25. The back-contact solar-cell interconnection structure according to claim 18, **characterized in that** a surface of the conductive metal wire is provided with a hot-melt conducting layer, and the hot-melt conducting layer is configured for electrically connecting a back electrode of the back-contact solar-cell sheet with the conductive composite panel.

26. The back-contact solar-cell interconnection structure according to claim 18, **characterized in that** the back-contact solar-cell sheet is a whole cell sheet or a solar-cell sub-sheet formed by cutting.

27. The back-contact solar-cell interconnection structure according to claim 18, **characterized in that** the conductive composite panel is formed by a laminating process, wherein the laminating is performed at a temperature ranging from 135°C to 165°C, and the laminating lasts for 6 minutes to 30 minutes.

28. A double-sided back-contact solar-cell module, **characterized in that** the double-sided back-contact solar-cell module comprises a front cover panel, a front packaging material, the back-contact solar-cell interconnection structure according to any one of claims 18 to 27 and a back cover panel from top to bottom in sequence.

29. The double-sided back-contact solar-cell module according to claim 28, **characterized in that** the back cover panel is made of a transparent material or a material which is transparent after being laminated.

30. The double-sided back-contact solar-cell module according to claim 28, **characterized in that** the back cover panel is tempered glass, or the back cover panel is a polymer back panel which is transparent after being laminated.

31. The double-sided back-contact solar-cell module according to claim 28, **characterized in that** a substrate layer of the polymer back panel is polyethylene glycol terephthalate, and fluorocarbon coatings are coated on both sides of the substrate layer.
